# EUROPEAN PATENT APPLICATION

(11) **EP 2 390 918 A2**
(43) Date of publication of application: **30.11.2011**
(21) Application number: 10190698.0
(22) Date of filing: 10.11.2010
(51) Int. Cl.: H01L 25/16, H01L 33/00, H05B 33/08

(54) **Light emitting device using AC and manufacturing method of the same**

(30) Priority: 24.05.2010 CN 201010190052
(71) Applicant: APT Electronics Ltd., Nansha District Guangzhou City Guangdong 511485 (CN)
(72) Inventor: Zhou, Yugang, 511485 Nansha District, Guangzhou City (CN); Zeng, Zhaoming, 511485 Nansha District, Guangzhou City (CN); Lai, Yin Hing, 511485 Nansha District, Guangzhou City (CN); Keung, Chi Wing, 511485 Nansha District, Guangzhou City (CN); Xu, Chaojun, 511485 Nansha District, Guangzhou City (CN); Wang, Ruizhen, 511485 Nansha District, Guangzhou City (CN); Xiao, Guowei David, 511485 Nansha District, Guangzhou City (CN)
(74) Representative: Davies, Philip

(57) **Abstract**

The present invention relates to a light emitting device using AC, comprising: at least one LED chip and an AC driving circuit chip, wherein the AC driving circuit chip comprises a substrate and a rectifying circuit integrated on the substrate. The LED chip is flipped and bonded on the AC driving circuit chip by flip-chip technology and electrically connected to the rectifying circuit, and the AC driving circuit chip converts the AC into DC for supply to the LED chip. The present invention further relates to a method of manufacturing the light emitting device using AC, comprising the following steps of: (1) forming an LED chip; (2) integrating a rectifying circuit on a substrate, forming two power source connecting terminals on the substrate, and forming an AC driving circuit chip; and (3) flip-chip bonding the LED chip on the AC driving circuit chip and in electrical connection with the rectifying circuit on the substrate. The light emitting device according to the present invention can be used by being directly connected to AC without needing any external integrated circuit device or electronic parts, thereby saving the assembling space and improving flexibility in use and meanwhile enhancing use efficiency of the light emitting regions.

## Description

### Field of the Invention

The present invention belongs to the field of manufacture of light emitting devices, relates to a structure of a light emitting device and a manufacturing method thereof, particularly to a light emitting device directly using alternating current (AC) and a manufacturing method thereof.

### Background of the Invention

Light-emitting diodes (LEDs) are advantageous in high efficiency, long service life and free of hazardous substances such as Hg. In the recent several years, with rapid improvement of the performances such as brightness and service life of the LEDs and decreasing of cost, LEDs are applied to more and more fields, including outdoor lighting such as street lamps, indoor lighting, and decorative lights etc.

The conventional lighting power sources use AC as power source. A cycle of AC comprises two half cycles opposite in direction of electrical current. However, an LED requires supply of DC power source. Therefore, when AC is employed in LEDs as power source, currently it is employed in the following several modes in general:
For example, US patent publication No.US20100060181 discloses an AC LED has an external integrated circuit device and comprises a current converter and a rectifier for converting AC into DC to supply DC power source for the LED.

Again for example, Chinese patent No.CN201043720 discloses an AC LED lamp. A plurality of kinds of electronic elements such as a resistor, a capacitor and diodes which form an AC/DC converting circuit and a protective circuit, are connected in series between the AC power source and the LED so that the LED can be directly connected to AC for use.

The above two technical solutions both require the LED to be used in cooperation with an external AC/DC converter or jointly used together with a functional circuit composed of electronic elements. However, these external devices all need to occupy partial space of the LED light source and affect flexibility in the installation and use of the LED.

Besides, a plurality of LEDs are arranged in different connection modes and then are connected to the AC power source. For example, the Chinese patent publication No.CN101586791 discloses an LED lamp, wherein two sets of LEDs opposite in polarity are connected in parallel and then connected to the AC power source. As such, in each half cycle in a single electrical current direction, only one of the sets of LED lamps are lit. Alternatively, as a variation of the technical solution, by designing and wiring on an LED chip, the single LED chip is divided into a plurality of different light emitting regions which are electrically connected in series or in parallel. Likewise, in each half cycle in a single electrical current direction, only a part of the light emitting regions are lit. In the two technical solutions, part of the LEDs or part of the light emitting regions of the LED chip are idle in half cycle so that all the LEDs or all the light emitting regions of the LED chip cannot sufficiently and simultaneously utilized and also the utilization coefficient of the light emitting regions of the LED is dereased.

### Summary of the Invention

One purpose of the present invention is to overcome shortcomings and drawbacks in the prior art and provide a light emitting device which can directly use AC power source and exhibit a high luminance.

Meanwhile, the present invention further provides a method of manufacturing such light emitting device which can directly use AC power source and exhibit a high luminance.

A light emitting device using AC, comprising at least one LED chip and an AC driving circuit chip, wherein the AC driving circuit chip comprises a substrate and a rectifying circuit integrated on the substrate, the LED chip is flip bonded on the substrate of the AC driving circuit chip and electrically connected to the rectifying circuit, and the AC driving circuit chip converts the AC into DC and supplies to the LED chip.

The rectifying circuit is a bridge rectifying circuit.

Furthermore, the rectifying circuit comprises a first diode, a second diode, a third diode and a fourth diode; an upper surface of the substrate is covered with an insulating layer, a contact hole e is provided at the insulating layer corresponding to a P electrode and an N electrode of the diodes, a first metal wire layer is provided on an upper surface of the insulating layer and respectively electrically connected to the P electrode and N electrode of each diode through the contact hole e; the P electrode of the first diode and the N electrode of the fourth diode are connected to a power source connecting terminal via the first metal wire layer, and the P electrode of the second diode and the N electrode of the third diode are connected to another power source connecting terminal via the first metal wire layer; the N electrodes of the first diode and the second diode are electrically connected through the first metal wire layer to form an N-type connecting terminal; the P electrodes of the third diode and the fourth diode are electrically connected through the first metal wire layer to form a P-type connecting terminal; the P electrode of the LED chip is electrically connected to the N-type connecting terminal, and the N electrode of the LED chip is electrically connected to the P-type connecting terminal.

Further, on upper surfaces of the P-type connecting terminal and the N-type connecting terminal are respectively provided a under bump metallurgy (UBM) layer, and on upper surfaces of the two power source connecting terminals are respectively provided an external bond pad.

On an upper surface of the UBM layer is provided a metal bump, and the LED chip is electrically connected to the substrate through the metal bump.

Furthermore, the light emitting device comprises a LED chip, wherein the LED chip comprises a plurality of mutually independent light emitting regions, each of the light emitting regions has a P electrode and N electrode, and the light emitting regions are connected in series or in parallel or in series and parallel through a second metal wire layer on the LED chip, the P electrode of a front-end light emitting region of the LED chip is electrically connected to the N-type connecting terminal of the substrate, and the N electrode of a rear-end light emitting region is electrically connected to the P-type connecting terminal of the substrate.

Alternatively, the light emitting device comprises an LED chip, wherein the LED chip comprises a plurality of mutually independent light emitting regions, each of the light emitting regions has a P electrode and N electrode, and the light emitting regions are connected in series or in parallel or in series and parallel through the first metal wire layer on the substrate, the P electrode of a front-end light emitting region of the LED chip is electrically connected to the N-type connecting terminal of the substrate, and the N electrode of a rear-end light emitting region is electrically connected to the P-type connecting terminal of the substrate.

Again alternatively, the light emitting device comprises a plurality of mutually independent LED chips, each of the LED chips has a P electrode and an N electrode, the LED chips are connected in series or in parallel or in series and parallel through the first metal wire layer on the substrate, the P electrode of a front-end LED chip is electrically connected to the N-type connecting terminal of the substrate, and the N electrode of a rear-end LED chip is electrically connected to the P-type connecting terminal of the substrate.

Furthermore, the light emitting device further comprises a filter circuit which is integrated on the substrate of the AC driving circuit chip and connected in series between the rectifying circuit and the power source connecting terminal.

The filter circuit consists of a resistor and a capacitor which are mutually connected in parallel.

The resistor is disposed on the upper surface of the insulating layer of the substrate, and is in a winding shape on the surface of the insulating layer.

The resistor is structured in three layers: a conductive layer-an insulating layer-a conductive layer, wherein the conductive layer on the bottom of the capacitor is disposed on the insulating layer and electrically connected to the first metal wire layer, and the conductive layer on the top of the capacitor is connected through a third metal wire layer to the first metal wire layer connected to the power source connecting terminal.

A material of the substrate is silicon wafer or silicon carbide or silicon on an insulator.

A method of manufacturing the light emitting device using AC comprises the following steps:
(1) forming an LED chip;
(2) integrating a rectifying circuit on the substrate, forming two power source connecting terminals on the substrate, and forming an AC driving circuit chip;
(3) flip-chip bonding the LED chip on the AC driving circuit chip and in electrical connection with the rectifying circuit.

Furthermore, the step (2) specifically comprises the following steps:
S1: respectively forming, on the substrate, the first diode, the second diode, the third diode and the fourth diode by ion implantation process in cooperation with photolithograpy process;
S2: forming on the upper surface of the substrate an insulting layer;
S3: forming the contact hole at the insulating layer corresponding to the P and N electrodes of the diodes;
S4: forming on the upper surface of the insulating layer the first metal wire layer which is electrically connected to the P electrodes and N electrodes of the respective diodes through the contact hole; the N electrodes of the first diode and the second diode are electrically connected through the first metal wire layer to form an N-type connecting terminal; the P electrodes of the third diode and the fourth diode are electrically connected through the first metal wire layer to form a P-type connecting terminal; the P electrode of the first diode and the N electrode of the fourth diode are connected via the first metal wire layer and form a power source connecting terminal on the substrate, and the P electrode of the second diode and the N electrode of the third diode are connected via the first metal wire layer and form another power source connecting terminal on the substrate.

The step (3) is specifically electrically connecting the P electrode of the LED chip to the N-type connecting terminal, and electrically connecting the N electrode of the LED chip to the P-type connecting terminal.

Furthermore, the step (2) further comprises the following steps:
S5: forming the UBM layer at the P-type connecting terminal of the first metal wire layer and the upper surface of the N-type connecting terminal, and forming an external bonding pad on the upper surface of the power source connecting terminal.
S6: forming the metal bump on the upper surface of the UBM layer.

The step (3) is specifically electrically connecting the P electrode and N electrode of the LED chip respectively to the metal bump corresponding to the N-type connecting terminal and the P-type connecting terminal.

Furthermore, there is a further step between the steps (2) and (3): integrating a filter circuit on the substrate in the following specific steps:
D1: forming the resistor on the upper surface of the insulating layer;
D2: forming the first conductive layer of the capacitor on the upper surface of the insulating layer, wherein the first conductive layer is connected to the first metal wire layer of the substrate;
D3: forming an insulating layer on the upper surface of the first conductive layer of the capacitor;
D4: forming a second conductive layer on the upper surface of the insulating layer of the capacitor;
D5: forming the third metal wire layer on the upper surface of the insulating layer of the substrate and the upper surface of the second conductive layer of the capacitor, wherein the third metal wire layer is wired and connected to the first metal wire layer connected to the power source connecting terminal.

Furthermore, the step (1) comprises a step of: forming a plurality of mutually insulative light emitting regions, each of which has a P electrode and an N electrode.

Furthermore, the step (1) further comprises a step of: forming on the light emitting region a second metal wire layer which electrically connects adjacent P electrode and N electrode of adjacent light emitting regions so that the light emitting regions are connected in series.

As compared with the prior art, the LED chip of the present invention can be used by being directly connected to AC with no need of any external integrated circuit device or electronic parts, thereby saving the assembling space and improving flexibility in use and meanwhile enhancing use efficiency of the light emitting regions.

As compared with the prior art, the light emitting device according to the present invention is manufactured by a method of directly flip bonding the LED chip to the AC driving circuit chip so that the product does not need any external integrated circuit device or electronic parts, thereby saving the assembling space and improving flexibility in use.

Preferred embodiments of the present invention will be described with reference to the drawings to make the present invention more apparent and comprehensible.

### Brief Description of the Accompanying Drawings

Fig. 1 is a schematic view of a light emitting device using AC according to the present invention;
Fig.2 is a schematic view of a circuit of a first embodiment of the light emitting device using AC according to the present invention;
Fig.3 is a cross-sectional view of the first embodiment of the light emitting device according to the present invention;
Fig.4 is a top view of a surface of a substrate of the light emitting device shown in Fig.3;
Fig.5 is a cross-sectional view of a second embodiment of the light emitting device according to the present invention;
Fig.6 is a top view of a surface of a substrate of the light emitting device shown in Fig.5;
Fig.7 is a schematic view of a circuit of the light emitting device using AC according to a third embodiment of the present invention;
Fig.8 is a cross-sectional view of the light emitting device according to the third embodiment of the present invention;
Fig.9 is a top view of a surface of the substrate of the light emitting device shown in Fig.8.

### Detailed Description of Preferred Embodiments

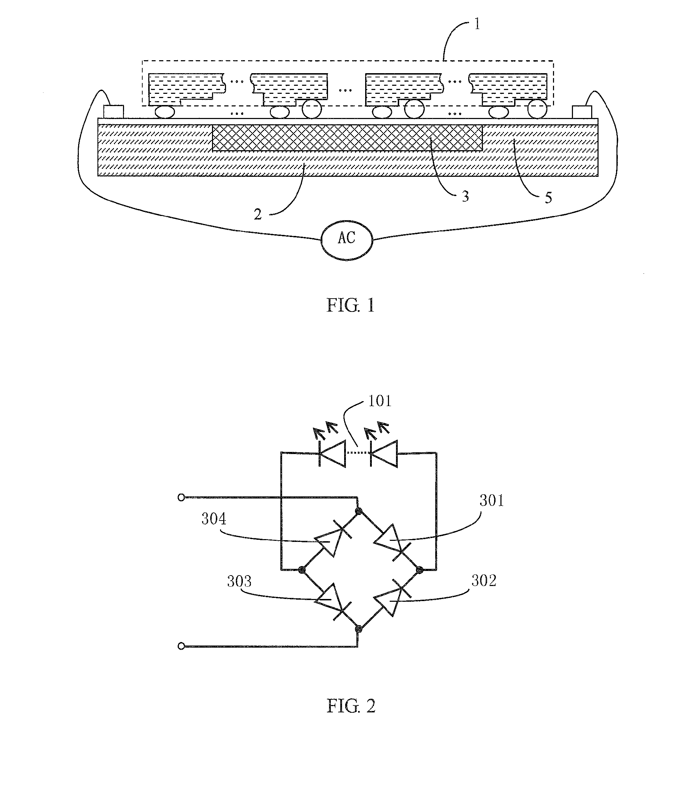

Referring to Fig.1, it shows a schematic view of a light emitting device using AC according to the present invention. The light emitting device comprises an LED chip 1 and an AC driving circuit chip 5, wherein the AC driving circuit chip 5 comprises a substrate 2 and a rectifying circuit 3 integrated on the substrate, the LED chip 1 is flip-chip bonded on the AC driving circuit chip 5 and electrically connected to the rectifying circuit 3. On each of both ends of the substrate 2 of the AC driving circuit chip 5 is provided a power source connecting terminal for externally connecting an AC power source. The LED chip 1 has a plurality of mutually independent light emitting regions 101 which are connected in series or in parallel.

### Embodiment 1

Referring to Fig.2, it is a schematic view of a circuit of a first embodiment of the light emitting device using AC according to the present invention. The rectifying circuit 3 comprises a first diode 301, a second diode 302, a third diode 303 and a fourth diode 304. The first diode 301 and the fourth diode 304 are connected in series to form a first branch, the second diode 302 and the third diode 303 are connected in series to form a second branch, and the first branch and the second branch are connected in parallel to form an AC/DC bridge rectifier. The first branch and the second branch, after being connected in parallel, are connected in series with each light emitting region 101 in the LED chip 1. A connection point between the first diode 301 and the fourth diode 304, and a connection point between the second diode 302 and the third diode 303 are respectively electrically connected to the power source connecting terminals on the substrate 2 of the AC driving circuit chip 5, thereby being externally connected to the AC power source.

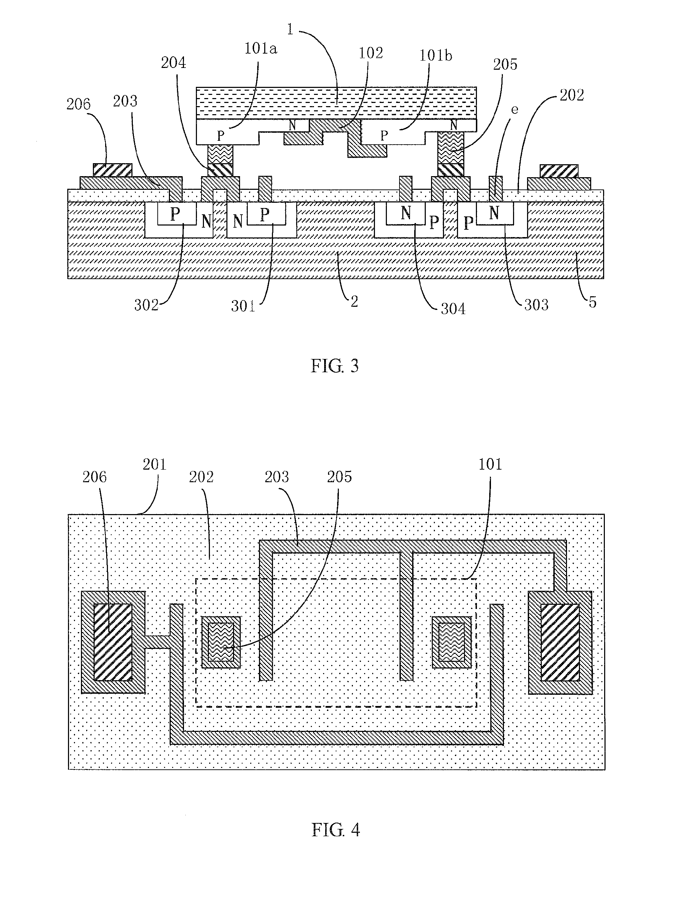

Referring to Fig.3 and Fig.4, Fig.3 is a cross-sectional view of the first embodiment of the light emitting device according to the present invention; and Fig.4 is a top view of a surface of a substrate of the light emitting device shown in Fig.3.

The LED chip 1 is divided into two light emitting regions 101a and 101b, each light emitting region 101 has a P electrode and an N electrode, the N electrode of the light emitting region 101a is adjacent to the P electrode of the light emitting region 101b, and they are electrically connected to each other through a second metal wire layer 102.

The rectifying circuit 3 is integrated on the substrate 2 to form the AC driving circuit chip 5. Specifically speaking, on the substrate 2 are formed the first diode 301, the second diode 302, the third diode 303 and the fourth diode 304. An upper surface of the substrate 2 is covered with an insulating layer 202, a contact hole e is provided at the insulating layer 202 corresponding to the P and N electrodes of the diode, a first metal wire layer 203 is provided on an upper surface of the insulating layer 202 and respectively electrically connected to the P and N electrodes of each diode through the contact hole e. The first diode 301 and the second diode 302 are P-N type diodes, wherein the N electrodes thereof are electrically connected through the first metal wire layer 203 to form an N-type connecting terminal; the third diode 303 and the fourth diode 304 are N-P type diodes, wherein the P electrodes thereof are electrically connected through the first metal wire layer 203 to form a P-type connecting terminal. The P electrode of the first diode 301 and the N electrode of the fourth diode 304 are connected to a power source connecting terminal via the first metal wire layer 203, and the P electrode of the second diode and the N electrode of the third diode are connected to another power source connecting terminal via the first metal wire layer 203. On upper surfaces of the P-type connecting terminal and the N-type connecting terminal are respectively provided a UBM layer, and on upper surfaces of the two power source connecting terminals are respectively provided an external bond pad 206. On an upper surface of the UBM layer 204 is provided a metal bump 205.

The LED chip 1 is flip-chip bonded on the AC driving circuit chip 5 , the P electrode of the first light emitting region of the LED chip 1 is connected to the metal bump 205 which corresponds to the N-type connecting terminal of the substrate 2, and the N electrode of the second light emitting region is connected to the metal bump 205 which corresponds to the P-type connecting terminal of the substrate 2.

A method of manufacturing the light emitting device using AC according to Embodiment 1 is described in detail hereunder.
(1) On the LED chip 1 are formed a plurality of mutually insulating light emitting regions 101 each of which has a P electrode and an N electrode. The second metal wire layer 102 is formed in a manner of electron beam evaporation in cooperation with lithography and etching process, wherein the second metal wire layer 102 electrically connects adjacent P electrode and N electrode of adjacent light emitting regions so that all the light emitting regions are connected in series, and wherein the second metal wire layer 102 is made of aluminum or other metals.
(2) The rectifying circuit 3 is integrated on the substrate 2 to form the AC driving circuit chip 5. Specific steps are as follows:
   S1: respectively forming, on the substrate 2 made of silicon wafers, the first diode 301, the second diode 302, the third diode 303 and the fourth diode 304 by ion implantation process in cooperation with photolithograpy process.
   S2: forming on the upper surface of the substrate 2 an insulting layer 202 which is formed by growing a high-temperature silicon dioxide layer at a high temperature by using a chemical vapor deposition tube furnace.
   S3: forming the contact hole e at the insulating layer 202 corresponding to the P and N electrodes of the diodes by combining lithography with a corrosion process.
   S4: forming on the upper surface of the insulating layer 202 the first metal wire layer 203 which is electrically connected to the P electrodes and N electrodes of the respective diodes through the contact hole e. The first metal wire layer 203 is formed by spluttering in cooperation with lithography and peeling process and is made of aluminum or other metals.
   S5: forming the UBM layer 204 and an external bond pad 206 on the upper surface of the first metal wire layer 203.
   S6: forming the metal bump 205 on the upper surface of the UBM layer 204 by a plating process, wherein the metal bump 205 can be made of a single metal such as gold or of a plurality of layers of materials or alloys.
(3) flip-chip connecting the LED chip 1 to the metal bump 205 of the substrate 2 of the AC driving circuit chip 5. The flip-chip connection can be effected by a binding and bonding method after pressurizing, heating and applying ultrasound.

### Embodiment 2

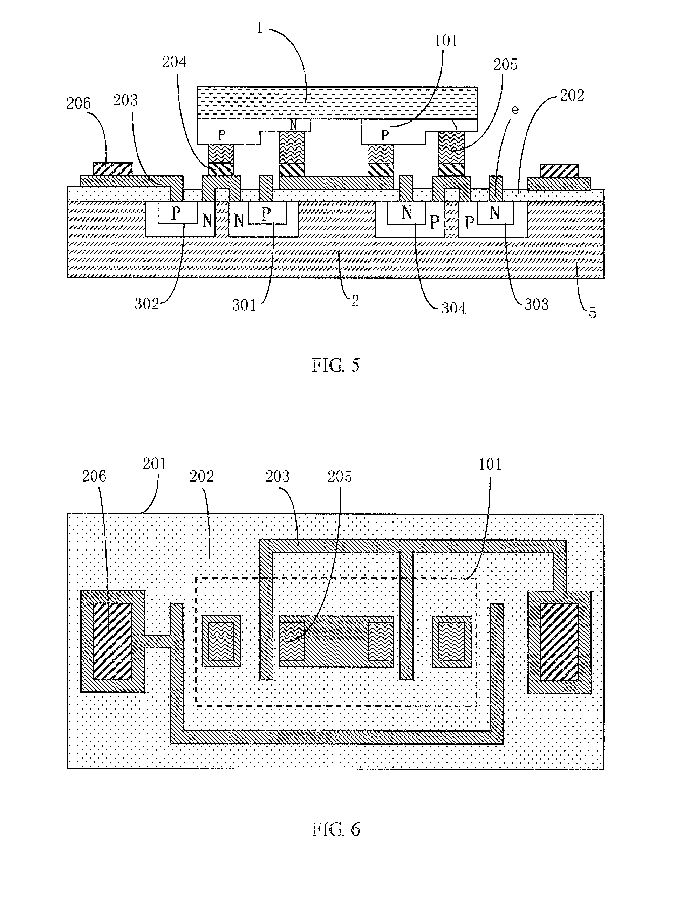

Simultaneously referring to Fig.5 and Fig.6, Fig.5 is a cross-sectional view of a second embodiment of the light emitting device according to the present invention, and Fig.6 is a top view of a surface of a substrate of the light emitting device shown in Fig.5.

The light emitting device according to Embodiment 2 is structurally substantially the same as that in Embodiment 1. The same rectifying circuit 3 is integrated on the substrate 2. The only difference between the two embodiments is that the P electrode and N electrode of the light emitting region 101 on the light emitting diode chip 1 are both connected to the metal bump 205 of the substrate 2 by flip-chip, i.e., adjacent N electrode and P electrode in two adjacent light-emitting regions 101 are respectively connected to the metal bump 205 at a corresponding position of the upper surface of the substrate 2, and achieve in-series connection through the first metal wire layer 203 on the substrate 2.

A method of manufacturing the light emitting device according to Embodiment 2 specifically comprises the following steps:
(1) On the LED chip 1 are formed a plurality of mutually insulating light emitting regions 101 each of which has a P electrode and an N electrode.
(2) The rectifying circuit 3 is integrated on the substrate 2 to form the AC driving circuit chip 5. Specific steps are as follows:
   S1: respectively forming, on the substrate 2 made of silicon wafers, the first diode 301, the second diode 302, the third diode 303 and the fourth diode 304 by ion implantation process in cooperation with photolithograpy process.
   S2: forming on the upper surface of the substrate 2 an insulting layer 202 which is formed by growing a high-temperature silicon dioxide layer at a high temperature by using a chemical vapor deposition tube furnace.
   S3: forming the contact hole e at the insulating layer 202 corresponding to the P and N electrodes of the diodes by combining lithography with a corrosion process.
   S4: forming on the upper surface of the insulating layer 202 the first metal wire layer 203 which is electrically connected to the P electrodes and N electrodes of the respective diodes through the contact hole e. The first metal wire layer 203 is formed by spluttering in cooperation with lithography and peeling process and is made of aluminum or other metals.
   S5: forming the UBM layer 204 and an external bond pad 206 on the upper surface of the first metal wire layer 203.
   S6: forming the metal bump 205 on the upper surface of the UBM layer 204 by stencil printing technology, wherein the metal bump 205 can be made of a material such as lead tin paste.
(3) flip-chip connecting the LED chip 1 to the metal bump 205 of the substrate 2. The flip-chip connection can be effected by a binding and bonding method chiefly with a reflow soldering.

### Embodiment 3

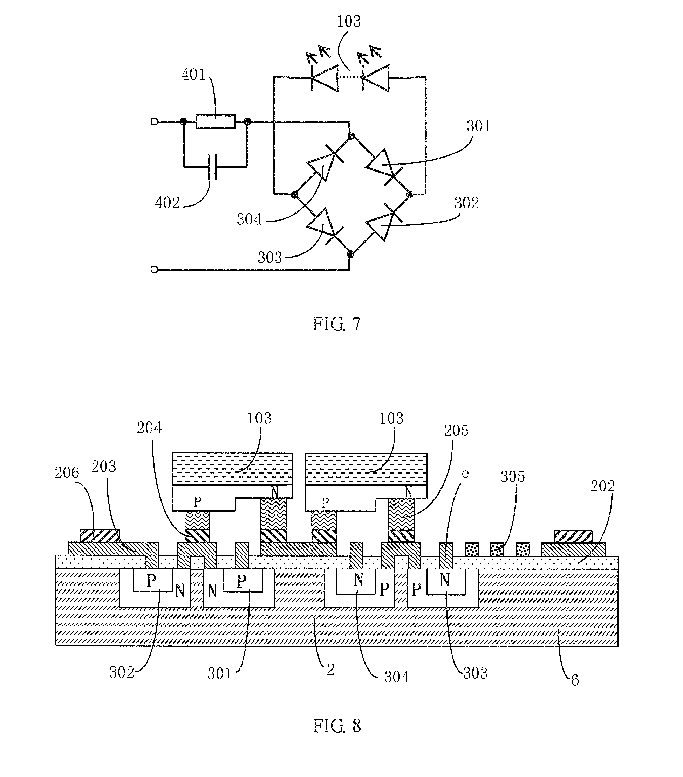

Referring to Fig.7, Fig.7 is a schematic view of a circuit of the light emitting device using AC according to a third embodiment of the present invention. The circuit of the light emitting device comprises a plurality of LED chips 103, a rectifying circuit 3 and a filter circuit 4. The plurality of LED chips 103 are mutually connected in series. The filter circuit 4 comprises a resistor 401 and a capacitor 402 connected in parallel. The rectifying circuit 3 is a bridge rectifying circuit which is structured the same as the rectifying circuit of Embodiment 1. The filter circuit 4 is connected in series at a power source input end of the rectifying circuit 3. The plurality of LED chips 103 connected in series are connected in series at an output end of the rectifying circuit 103.

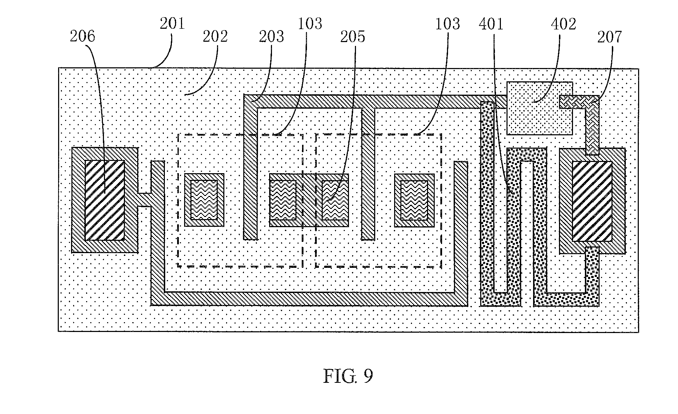

Referring to Fig.8 and Fig.9, Fig.8 is a cross-sectional view of the light emitting device according to the third embodiment of the present invention, and Fig.9 is a top view on surface of the substrate of the light emitting device shown in Fig.8.

The LED chip 103 has a light emitting region which has a P electrode and an N electrode.

The rectifying circuit 3 and the filter circuit 4 are together integrated on the substrate 2 to form the AC driving circuit chip 6, the filter circuit 4 is disposed between the rectifying circuit 3 and a power source connecting terminal. The integrated circuit wiring of the rectifying circuit 3 is identical with that in Embodiment 2. The resistor 401 of the filter circuit 4 is disposed on the upper surface of the insulating layer 202 on the upper surface of the substrate. It increases the length because the resistor 401 can be provided in a winding shape according to a present resitivity, and thereby it increases the resisitivity of the resistor 401. The resistor 401 is made of polycrystalline silicon, and is structured in three layers: a conductive layer and an insulating layer and a conductive layer (not shown in Figs). Besides, the conductive layer on the bottom is disposed on the insulating layer 202 and electrically connected to the first metal wire layer 203, and the conductive layer on the top of the capacitor 402 is connected through a third metal wire layer 207 to the first metal wire layer 203 connected to the power source connecting terminal.

The plurality of LED chips 103 are flip-chip bonded on the substrate 2 of the AC driving circuit chip 6, the P electrode and the N electrode of each of the LED chips 103 are respectively connected to the metal bump 205 at the corresponding position on the substrate 2, in order to form a circuit loop of the light emitting device shown in Fig.7.

A manufacturing method about the light emitting device according to Embodiment 3 specifically comprises the following steps in detail:
(1) making at least one LED chip, each of which has a P electrode and an N electrode.
(2) integrating the rectifying circuit 3 on the substrate 2, comprising the following specific steps:
   S 1: respectively forming, on the substrate 2 which be made of silicon wafers, the first diode 301, the second diode 302, the third diode 303 and the fourth diode 304 by ion implantation process in cooperation with photolithograpy process.
   S2: forming an insulting layer 202 on the upper surface of the substrate 2, which is formed by growing a high-temperature silicon dioxide layer at a high temperature by using a chemical vapor deposition tube furnace.
   S3: forming the contact hole e at the insulating layer 202 corresponding to the P and N electrodes of the diodes by combining lithography with a corrosion process.
   S4: forming on the upper surface of the insulating layer 202 the first metal wire layer 203 which is electrically connected to the P electrodes and N electrodes of the respective diodes through the contact hole e. The first metal wire layer 203 is formed by spluttering in cooperation with lithography and peeling process and is made of aluminum or other metals.
   S5: forming the UBM layer 204 and the external bonding pad 206 on the upper surface of the first metal wire layer 203.
   S6: forming the metal bump 205 on the upper surface of the UBM layer 204 by a plating process, and the metal bump 205 can be made of a single metal such as gold or of a plurality of layers of materials or alloys.
(3) integrating the filter circuit 4 on the substrate 2, comprising the following steps:
   D1: forming the resistor 401 on the upper surface of the insulating layer 202;
   D2: forming the first conductive layer of the capacitor 402 on the upper surface of the insulating layer 202, wherein the first conductive layer is connected to the first metal wire layer 203 of the substrate;
   D3: forming an insulating layer on the upper surface of the first conductive layer of the capacitor 402;
   D4: forming a second conductive layer on the upper surface of the insulating layer of the capacitor 402;
   D5: forming the third metal wire layer 207 on the upper surface of the insulating layer 202 of the substrate 2 and the upper surface of the second conductive layer of the capacitor 402, where the third metal wire layer 207 is wired and connected to the first metal wire layer 203 connected to the power source connecting terminal, the third metal wire layer 207 can be formed by spluttering in cooperation with lithography and a peeling process, and the third metal wire layer 207 is made of aluminum or other metals.
(4) flip-chip connected the LED chip 103 is bonded to the metal bump 205 of the substrate 2. The flip-chip connection can be completed by a binding and bonding method after pressurizing, heating and applying ultrasound.

In Embodiment 3, the manufacturing steps of the filter circuit 4 can be finished between S4 and S5. The UBM layer 204, the external bond pad 206 and the metal bump 205 are formed after the rectifying circuit 3 and the filter circuit 4 are integrated on the substrate 2.

The methods for manufacturing the integrated devices in the embodiments of the present invention can be exchanged for use. Further, the rectifying circuit of the present invention is not limited to the bridge rectifying circuit formed by the diodes connected in series and parallel, and it can be a rectifying circuit with other structures. The AC driving circuit chip of the present invention can further be integrated with circuits or elements in other forms so that the AC/DC conversion function becomes more stable. Moreover, the light emitting regions in the LED chips or one LED chip of the present invention can not only be connected in series, but also connected in parallel or connected simultaneously in series and parallel.

As compared with the prior art, in the present invention the rectifying circuit is integrated on the substrate to form the AC driving circuit chip and then the LED chip is directly flip-chip bonded on the AC driving circuit chip so that AC power source can be directly introduced in the light emitting device without needing any external integrated circuit device or electronic parts, thereby it can save the assembling space and improving flexibility in using. Furthermore, according to the present invention, the LED chip is flip-chip bonded on the substrate, and does not require connection modes such as routing or circuit board connection, thereby improving its reliability. Besides, no matter whether different light emitting regions on a single LED chip or a plurality of LED chips are directly connected to the AC for using, all the LED chips or light emitting regions, in a suitable range of voltage, are drived by two electrical current directions of the AC power source, and all the light emitting regions of the LED are sufficiently utilized, inducing the using efficiency of the light emitting regions improved.

The present invention is not limited to the above embodiments. If various modification or variations to the present invention do not depart from the spirit and scope of the present invention, the present invention also intends to contain the various modifications and variations if they fall within the scope of claims of the present invention and equivalent technologies.

## Claims

1. A light emitting device using AC, **characterized in that** it comprises:
at least one LED chip; and
an AC driving circuit chip comprising a substrate and a rectifying circuit integrated on the substrate;
the LED chip is flipped and bonded on the AC driving circuit chip using flip-chip technology and electrically connected to the rectifying circuit, and the AC driving circuit chip converts the AC into DC for supply to the LED chip.

2. The light emitting device according to claim 1, **characterized in that** the rectifying circuit is a bridge rectifying circuit.

3. The light emitting device according to claim 2, **characterized in that** the bridge rectifying circuit comprises a first diode, a second diode, a third diode and a fourth diode formed on the substrate; an upper surface of the substrate is covered with an insulating layer, a contact hole is provided at the insulating layer corresponding to the P electrodes and the N electrodes of the diodes; a first metal wire layer is provided on the upper surface of the insulating layer and respectively electrically connected to the P and N electrodes of the diodes through the contact holes; the P electrode of the first diode and the N electrode of the fourth diode are connected to a power source connecting terminal on the substrate via the first metal wire layer, and the P electrode of the second diode and the N electrode of the third diode are connected to another power source connecting terminal of the substrate via the first metal wire layer; the N electrodes of the first diode and the second diode are electrically connected through the first metal wire layer to form an N-type connecting terminal; the P electrodes of the third diode and the fourth diode are electrically connected through the first metal wire layer to form a P-type connecting terminal; the P electrode of the LED chip is electrically connected to the N-type connecting terminal, and the N electrode of the LED chip is electrically connected to the P-type connecting terminal.

4. The light emitting device according to claim 3, **characterized in that** on upper surfaces of the P-type connecting terminal and the N-type connecting terminal are respectively provided a UBM layer, and on upper surfaces of the two power source connecting terminals are respectively provided an external bond pad.

5. The light emitting device according to claim 4, **characterized in that** on an upper surface of the UBM layer is provided a metal bump, and the LED chip is electrically connected to the substrate through the metal bump.

6. The light emitting device according to claim 3, **characterized in that** the light emitting device comprises an LED chip, wherein the LED chip comprises a plurality of mutually independent light emitting regions, each of the light emitting regions has a P electrode and N electrode, and the light emitting regions are connected in series or in parallel or in series and parallel through a second metal wire layer on the LED chip, the P electrode of a front-end light emitting region of the LED chip is electrically connected to the N-type connecting terminal of the substrate, and the N electrode of a rear-end light emitting region is electrically connected to the P-type connecting terminal of the substrate.

7. The light emitting device according to claim 3, **characterized in that** the light emitting device comprises an LED chip, wherein the LED chip comprises a plurality of mutually independent light emitting regions, each of the light emitting regions has a P electrode and N electrode, and the light emitting regions are connected in series or in parallel or in series and parallel through the first metal wire layer on the substrate, the P electrode of a front-end light emitting region of the LED chip is electrically connected to the N-type connecting terminal of the substrate, and the N electrode of a rear-end light emitting region is electrically connected to the P-type connecting terminal of the substrate.

8. The light emitting device according to claim 3, **characterized in that** the light emitting device comprises a plurality of mutually independent LED chips, each of the LED chips has a P electrode and an N electrode, the LED chips are connected in series or in parallel or in series and parallel through the first metal wire layer on the substrate, the P electrode of a front-end LED chip is electrically connected to the N-type connecting terminal of the substrate, and the N electrode of a rear-end LED chip is electrically connected to the P-type connecting terminal of the substrate.

9. The light emitting device according to claims 1, **characterized in that** the light emitting device further comprises a filter circuit which is integrated on the substrate of the AC driving circuit chip and connected in series between the rectifying circuit and the power source connecting terminal.

10. The light emitting device according to claim 9, **characterized in that** the filter circuit consists of a resistor and a capacitor which are mutually connected in parallel.

11. The light emitting device according to claim 10, **characterized in that** the resistor is disposed on the upper surface of the insulating layer of the substrate.

12. The light emitting device according to claim 11, **characterized in that** the resistor is in a winding shape on the surface of the insulating layer.

13. The light emitting device according to claim 10, **characterized in that** the capacitor is structured in three layers: a conductive layer and an insulating layer and a conductive layer, wherein the conductive layer on the bottom of the capacitor is disposed on the insulating layer and electrically connected to the first metal wire layer, and the conductive layer on the top of the capacitor is connected through a third metal wire layer to the first metal wire layer connected to the power source connecting terminal.

14. The light emitting device according to claim 1, **characterized in that** a material of the substrate is silicon wafer or silicon carbide or silicon on an insulator.

15. A method of manufacturing the light emitting device using AC, **characterized in that** the method comprises the following steps of:
(1) forming an LED chip;
(2) integrating a rectifying circuit on a substrate, forming two power source connecting terminals on the substrate, and forming an AC driving circuit chip; and
(3) flip-chip bonding the LED chip on the AC driving circuit chip and in electrical connection with the rectifying circuit.

16. The manufacturing method according to claim 15, **characterized in that** the step (2) specifically comprises the following steps:
S 1: respectively forming, on the substrate, a first diode, a second diode, a third diode and a fourth diode by ion implantation process in cooperation with photolithograpy process;
S2: forming on an upper surface of the substrate an insulting layer;
S3: forming a contact hole at the insulating layer corresponding to P and N electrodes of the diodes;
S4: forming on an upper surface of the insulating layer a first metal wire layer which is electrically connected to the P electrodes and N electrodes of the respective diodes through the contact hole; the N electrodes of the first diode and the second diode are electrically connected through the first metal wire layer to form an N-type connecting terminal; the P electrodes of the third diode and the fourth diode are electrically connected through the first metal wire layer to form a P-type connecting terminal; the P electrode of the first diode and the N electrode of the fourth diode are connected via the first metal wire layer and form a power source connecting terminal on the substrate, and the P electrode of the second diode and the N electrode of the third diode are connected via the first metal wire layer and form another power source connecting terminal on the substrate;
the step (3) is specifically electrically connecting the P electrode of the LED chip to the N-type connecting terminals, and electrically connecting the N electrode of the LED chip to the P-type connecting terminal.

17. The manufacturing method according to claim 16, **characterized in that** the step (2) further comprises the following steps:
S5: forming a UBM layer at the P-type connecting terminal of the first metal wire layer and the upper surface of the N-type connecting terminal, and forming an external bonding pad on the upper surface of the power source connecting terminal;
S6: forming a metal bump on the upper surface of the UBM layer;
the step (3) is specifically electrically connecting the P electrode and N electrode of the LED chip respectively to the metal bumps corresponding to the N-type connecting terminal and the P-type connecting terminal.

18. The manufacturing method according to claim 15, **characterized in that** there is a further step between the steps (2) and (3): integrating a filter circuit on the substrate in the following specific steps:
D1: forming a resistor on the upper surface of the insulating layer;
D2: forming a first conductive layer of a capacitor on the upper surface of the insulating layer, wherein the first conductive layer is connected to the first metal wire layer of the substrate;
D3: forming an insulating layer on an upper surface of the first conductive layer of the capacitor;
D4: forming a second conductive layer on the upper surface of the insulating layer of the capacitor;
D5: forming a third metal wire layer on the upper surface of the insulating layer of the substrate and an upper surface of the second conductive layer of the capacitor, wherein the third metal wire layer is wired and connected to the first metal wire layer connected to the power source connecting terminal.

19. The manufacturing method according to claim 15, **characterized in that** the step (1) comprises a step of: forming a plurality of mutually insulative light emitting regions, each of which has a P electrode and an N electrode.

20. The manufacturing method according to claim 19, **characterized in that** the step (1) further comprises a step of: forming on the light emitting region a second metal wire layer which electrically connects P electrode and N electrode of light emitting regions so that the light emitting regions are connected in series or in parallel or in series and parallel.
